# EUROPÄISCHE PATENTANMELDUNG

(11) **EP 0 825 715 A1**
(43) Veröffentlichungstag der Anmeldung: **25.02.1998**
(21) Anmeldenummer: 97113042.2
(22) Anmeldetag: 29.07.1997
(51) Int. Cl.: H03K 5/1252

(54) **Eingangsschaltung für digitale Signale**

(30) Priorität: 19.08.1996 DE 19633363
(71) Anmelder: SIEMENS AKTIENGESELLSCHAFT, 80333 München (DE)
(72) Erfinder: Maier, Willi, 77728 Oppenau (DE)

(57) **Zusammenfassung**

Um einen Empfang von digitalen Signalen ohne überlagerte Störsignale zu ermöglichen, enthält eine Eingangsschaltung für die digitalen Signale ein Tiefpaßfilter (2) mit nachgeordnetem Schwellenwertschalter (3) und Mittel (4, 13, 14) zur Inhibierung oder Schwächung der Tiefpaßwirkung bei jeder Änderung des Ausgangszustandes (U4) des Schwellenwertdetektors (3).

## Beschreibung

Bei der Übertragung von digitalen Signalen, insbesondere auf langen Leitungen, kann es zur Überlagerung von Störsignalen, z. B. Burst-Störimpulsen, kommen. Es besteht die Möglichkeit, zur Unterdrückung von die Störsignale erzeugenden Einflüssen abgeschirmte Leitungen zu verwenden, was jedoch sehr aufwendig sein kann.

Der Erfindung liegt daher die Aufgabe zugrunde, einen Empfang von digitalen Signalen ohne überlagerte Störsignale zu ermöglichen.

Gemäß der Erfindung wird die Aufgabe durch die in Anspruch 1 angegebene Eingangsschaltung gelöst.

Vorteilhafte Weiterbildungen der erfindungsgemäßen Eingangsschaltung sind den Unteransprüchen zu entnehmen.

Das Tiefpaßfilter und der nachgeordnete Schwellenwertschalter sind in der Weise ausgelegt, daß kurze Störimpulse, die auf die Eingangsschaltung gelangen, keine Verletzung der Schwelle des Schwellenwertschalters durch das Ausgangssignal des Tiefpaßfilters bewirken, so daß der Schwellenwertschalter seinen jeweiligen Ausgangszustand beibehält. Digitale Signale mit einer Mindestsignaldauer bewirken dagegen, daß das Ausgangssignal des Tiefpaßfilters mit einer auf die Vorderflanke des digitalen Signals folgenden Verzögerung die Schwelle überschreitet und mit entsprechender Verzögerung auf die Rückflanke des digitalen Signals die Schwelle unterschreitet, so daß der Schwellenwertschalter das digitale Signal verzögert rekonstruiert. Um zu verhindern, daß unmittelbar nach Schwellenüberschreitung ein kurzer Amplitudeneinbruch in dem digitalen Signal bzw. unmittelbar nach Schwellenunterschreitung ein auf das digitale Signal folgender Störimpuls zu einer Verletzung der Schwelle und damit zu einem fehlerhaften Umschalten des Schwellenwertschalters führen, wird bei jeder Änderung des Ausgangszustandes des Schwellenwertschalters die Tiefpaßwirkung des Tiefpaßfilters aufgehoben oder zumindest geschwächt. Dies geschieht bei einem Widerstands-Kondensator-Filter (RC-Filter) vorzugsweise durch eine Schnelladung bzw. Schnellentladung des Kondensators.

Durch eine dem Tiefpaßfilter vorgeschaltete Einrichtung zur Amplitudenbegrenzung lassen sich die der Eingangsschaltung zugeführten digitalen Signale und Störsignale auf einen festen Amplitudenwert begrenzen, so daß kurze Störsignale mit hoher Amplitude nicht zu einer Verletzung der Schwelle des Schwellenwertschalters führen.

Um die Funktionsfähigkeit der Eingangsschaltung beeinträchtigende Signalgleichanteile zurückzuhalten, ist dem Tiefpaßfilter vorzugsweise eine Potentialtrennstufe, insbesondere ein Optokoppler, vorgeschaltet.

Der Schwellenwertschalter ist vorzugsweise ein Schmitt-Trigger, mit dem sich zur Optimierung der Störsignalunterdrückung zwei unterschiedliche Schwellen einstellen lassen.

Zur weiteren Erläuterung der Erfindung wird im folgenden auf die Figuren der Zeichnung Bezug genommen; im einzelnen zeigen beispielhaft
- Figur 1: ein Blockschaltbild der erfindungsgemäßen Eingangsschaltung,
- Figur 2: ein detaillierteres Schaltbild der erfindungsgemäßen Eingangsschaltung und
- Figur 3: ausgewählte Signalverläufe aus den Schaltbildern der Figuren 1 und 2.

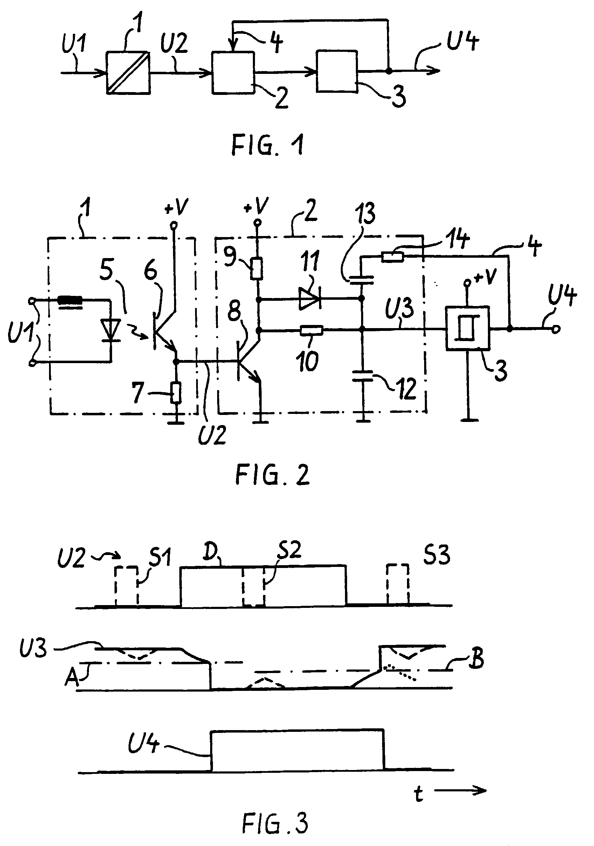

Die in Figur 1 gezeigte Eingangsschaltung für digitale Signale enthält eine Potentialtrennstufe 1, die die ihr zugeführten digitalen Signale und überlagerten Störsignale U1 von Signalgleichanteilen befreit und in ihrer Amplitude begrenzt. Das so gebildete Ausgangssignal U2 der Potentialtrennstufe 1 wird einem Tiefpaßfilter 2 zugeführt, dessen Ausgangssignal U3 auf einen Schwellenwertschalter 3 gelangt. Diese erzeugt ein Ausgangssignal U4 mit zwei unterschiedlichen Ausgangszuständen in Abhängigkeit davon, ob das Ausgangssignal U3 des Tiefpaßfilters 2 eine Schwelle über- oder unterschreitet. Das Tiefpaßfilter 2 weist einen Steuereingang 4 auf, über den die Tiefpaßwirkung bei jeder Änderung des Ausgangszustands U4 des Schwellenwertschalters 3 aufgehoben oder zumindest geschwächt wird.

Wie das detailliertere Schaltungsbeispiel in Figur 2 zeigt, enthält die Potentialtrennstufe 1, der die digitalen Signale mitsamt den überlagerten Störsignalen U1 zugeführt werden, einen Optokoppler 5, dessen ausgangsseitiger Fototransistor 6 mit einem Emitterwiderstand 7 in Kollektorschaltung an einer Versorgungsgleichspannung +V liegt. Die Spannung über dem Emitterwiderstand 7 entspricht dem von den Signalgleichanteilen befreiten und amplitudenbegrenzten Signal U2, das dem Tiefpaßfilter 2 zugeführt wird.

Dieses enthält eingangsseitig einen Transistor 8, der mit einem Kollektorwiderstand 9 in Emitterschaltung an der Versorgungsgleichspannung +V liegt. Zwischen dem Kollektor und dem Emitter des Transistors 8 liegt eine Reihenschaltung aus einem Widerstand 10 mit einer dazu parallelen Diode 11 und einem Kondensator 12. Die Spannung über dem Kondensator 12 entspricht dem Ausgangssignal U3 des Tiefpaßfilters 2 und ist dem Schwellenwertschalter 3, hier einem Schmitt-Trigger, zugeführt, dessen Ausgangssignal U4 den Potentialwert +V der Versorgungsgleichspannung annimmt, wenn das Signal U3 eine erste Schwelle überschreitet, und den Wert 0 annimmt, wenn das Signal U3 eine zweite Schwelle unterschreitet. Die Schwellen können gleich oder unterschiedlich sein. An dem Steuereingang 4 des Tiefpaßfilters 2 wird das Ausgangssignal U4 des Schwellenwertschalters 3 über eine Reihenschaltung aus einem Kondensator 13 und einem Widerstand 14 dem Kondensator 12 zugeführt.

Figur 3 zeigt von oben nach unten die Signalverläufe des Signals U2 am Eingang des Tiefpaßfilters 2, das Ausgangssignal U3 des Tiefpaßfilters 2 und das Ausgangssignal U4 des Schwellenwertschalters 3. Die auf dem der Eingangsschaltung zugeführten digitalen Signal beruhenden Signalverläufe sind mit durchgezogenen Linien und die auf Störsignalen beruhenden Signalverläufe mit gestrichelten Linien dargestellt.

Ein kurzes Störsignal, z. B. S1, führt dazu, daß der auf die Versorgungsgleichspannung +V aufgeladene Kondensator 12 über den Widerstand 10 und den Transistor 8 entladen und am Ende des Störsignals S1 über den Kollektorwiderstand 9 und die Diode 11 wieder aufgeladen wird, bevor die Spannung U3 an dem Kondensator 12 unter eine erste Schwelle A des Schwellenwertschalters 3 sinkt. Es tritt daher kein Wechsel des Ausgangszustandes U4 des Schwellenwertschalters 3 auf.

Entsprechendes gilt für das Störsignal S2, bei dem der Kondensator 12 über den Kollektorwiderstand 9 und die Diode 11 aufgeladen und am Ende des Störsignals S2 über den Widerstand 10 und den Transistor 8 wieder entladen wird, bevor die Spannung U3 am Kondensator 12 eine zweite Schwelle B des Schwellenwertdetektors 3 übersteigt.

Bei einem digitalen Signal D mit einer Mindestdauer unterschreitet dagegen die Kondensatorspannung U3 mit einer auf die Vorderflanke des digitalen Signals D folgenden Verzögerung die Schwelle A, woraufhin der Schwellenwertschalter 3 seinen Ausgangszustand U4 wechselt. Im Anschluß an die Rückflanke des digitalen Signals D überschreitet die Kondensatorspannung U3 nach einer Verzögerung die Schwelle B, woraufhin der Schwellenwertschalter 3 seinen Ausgangszustand U4 wieder wechselt. Auf diese Weise wird das digitale Signal D durch den Schwellenwertschalter 3 verzögert rekonstruiert.

Um zu verhindern, daß entsprechend der gepunkteten Darstellung der Schwellenwertschalter 3 fälschlicherweise seinen Zustand wechselt, wenn unmittelbar nach Unterschreiten der Schwelle A oder Überschreiten der Schwelle B durch die Kondensatorspannung U3 ein Störsignal, z. B. S3, auftritt, wird der Kondensator 12 bei jeder Änderung des Ausgangszustandes U4 des Schwellenwertschalters 3 über den Kondensator 13 und den strombegrenzenden Widerstand 14 schnellentladen bzw. schnellgeladen.

## Patentansprüche

1. Eingangsschaltung für digitale Signale (D) mit einem Tiefpaßfilter (2), einem nachgeordneten Schwellenwertschalter (3) zur Erzeugung zweier unterschiedlicher Ausgangszustände (U4), je nachdem, ob das Ausgangssignal (U3) des Tiefpaßfilters (2) eine Schwelle (A, B) über- oder unterschreitet, und mit Mitteln (4, 13, 14) zur Inhibierung oder Schwächung der Tiefpaßwirkung bei jeder Änderung des Ausgangszustandes (U4) des Schwellenwertschalters (3).

2. Eingangsschaltung nach Anspruch 1, dadurch gekennzeichnet, daß dem Tiefpaßfilter (2) eine Einrichtung zur Amplitudenbegrenzung vorgeschaltet ist.

3. Eingangsschaltung nach Anspruch 1 oder 2, dadurch gekennzeichnet, daß dem Tiefpaßfilter (2) eine Potentialtrennungsstufe (1) vorgeschaltet ist.

4. Eingangsschaltung nach Anspruch 3, dadurch gekennzeichnet, daß die Potentialtrennungsstufe (1) einen Optokoppler (5) enthält.

5. Eingangsschaltung nach einem der vorangehenden Ansprüche, dadurch gekennzeichnet, daß das Tiefpaßfilter (2) ein Widerstands-Kondensator-Filter (RC-Filter) ist und daß die Mittel (4, 13, 14) zur Inhibierung oder Schwächung der Tiefpaßwirkung eine Schnelladung bzw. Schnellentladung des Kondensators (12) bei jeder Änderung des Ausgangszustandes (U4) des Schwellenwertschalters (3) bewirken.

6. Eingangsschaltung nach einem der vorangehenden Ansprüche, dadurch gekennzeichnet, daß der Schwellenwertschalter (3) ein Schmitt-Trigger ist.

7. Eingangsschaltung nach einem der vorangehenden Ansprüche, dadurch gekennzeichnet, daß das Tiefpaßfilter (2) einen Transistor (8) in Emitterschaltung enthält, dessen Kollektor über einen Kollektorwiderstand (9) an einer Versorgungsgleichspannung (+V) liegt und zwischen dessen Kollektor und Emitter eine Reihenschaltung aus einem Widerstand (10) mit dazu paralleler Diode (11) und einem Kondensator (12) liegt, daß ein Schmitt-Trigger mit seinem Eingang an den Kondensator (12) geschaltet ist und daß der Ausgang des Schmitt-Triggers über ein Strombegrenzungsglied (13, 14) an den Kondensator (12) rückgekoppelt ist.
